## Europäisches Patentamt

## European Patent Office

## Office européen des brevets

(19)

(11) Veröffentlichungsnummer: **0 089 534**
**B1**

(12) # EUROPÄISCHE PATENTSCHRIFT

(45) Veröffentlichungstag der Patentschrift:
05.02.86

(21) Anmeldenummer: 83102182.9

(22) Anmeldetag: 05.03.83

(51) Int. Cl.⁴: **G 01 N 24/08**, A 61 B 5/05

(54) Verfahren zum Messen der magnetischen Kernresonanz.

(30) Priorität: **13.03.82 DE 3209263**

(43) Veröffentlichungstag der Anmeldung:
28.09.83 Patentblatt 83/39

(45) Bekanntmachung des Hinweises auf die Patenterteilung:
05.02.86 Patentblatt 86/6

(84) Benannte Vertragsstaaten:
**AT BE CH DE FR GB IT LI LU NL SE**

(56) Entgegenhaltungen:
**DE - A - 2 716 492**
**GB - A - 2 026 172**

(73) Patentinhaber: **Bruker Medizintechnik GmbH,
Silberstreifen, D-7512 Rheinstetten-Forchheim (DE)**

(72) Erfinder: **Post, Hans, Dr., Griethweg 23,
D-6905 Schriesheim (DE)**
Erfinder: **Ratzel, Dieter, Buchenweg 31,
D-7512 Rheinstetten (DE)**
Erfinder: **Brunner, Peter, Dr., Schumacherstrasse 13,
D-7505 Ettlingen (DE)**

(74) Vertreter: **Patentanwälte Kohler - Schwindling - Späth,
Hohentwielstrasse 41, D-7000 Stuttgart 1 (DE)**

LIBER, STOCKHOLM 1986

## Beschreibung

Die Erfindung betrifft ein Verfahren zum Messen der magnetischen Kernresonanz in einem ausgewählten Volumenelem ent eines Körpers, bei dem die sich in dem ausgewählten Volumenelement befindenden, interessierenden Kernspins mittels Hochfrequenzsignalen selektiv angeregt werden, während sie einem den gesamten Körper durchsetzenden, hochgradig homogenen, stationären Magnetfeld sowie stationären magnetischen Gradientenfeldern ausgesetzt sind, und bei dem Induktionssignale erzeugt und detektiert werden.

Ein solches Verfahren ist aus einer Druckschrift der Firma OXFORD Research Systems mit dem Titel "Topical Magnetic Resonance Spectroscopy" bekannt. Es ermöglicht, von ausgewählten Stellen eines größeren Körpers hochaufgelöste NMRSpektren zu erhalten. Solche hochaufgelösten Spektren von bestimmten Stellen eines Körpers gestatten beispielsweise die Beobachtung biochemischer Vorgänge im lebenden Körper, ohne daß ein mechanischer Eingriff in den Körper erforderlich wäre, wie beispielsweise Stoffwechselvorgänge im Muskelgewebe, in der Leber und dergleichen. Ein Bericht über solche Untersuchungen im lebenden Körper findet sich in Nature 287 (1980), Seiten 736 bis 738.

Bei dem bekannten Verfahren wird das Volumenelement, das für die hochauflösende NMR-Spektroskopie zur Verfügung steht, durch Anlegen eines komplizierten Gradientenfeldes bestimmt, das im Bereich des ausgewählten Volumenelementes eine im wesentlichen konstante Feldstärke hat und dessen Feldstärke sich in den angrenzenden Bereichen sehr stark ändert. Der Nachteil dieses bekannten Verfahrene besteht nicht nur darin, daß zur Erzeugung des sehr komplizierten Gradientenfeldes ein sehr hoher apparativer Aufwand erforderlich ist, sondern insbesondere auch darin, daß der Ort des ausgewählten Volumenelementes im wesentlichen durch die Lage von den Magnetspulen bestimmt ist, die zur Erzeugung der Gradientenfelder dienen, und daher in bezug auf diese Spulen nicht veränderbar ist. Infolgedessen ist es notwendig, einen Probekörper so zu plazieren, daß das zu beobachtende Volumenelement dieses Körpers genau in den Bereich der Spulenanordnung gebracht wird, in dem sich der homogene Bereich des Magnetfeldes befindet. Damit ist zumindest bei großvolumigen Probenkörpern nur die Auswahl von Volumenelementen möglich, die sich im Mittelbereich des Körpers befinden. Ein weiterer Nachteil des bekannten Verfahrens besteht darin, daß bei der Messung auch Signale empfangen werden, die aus den an das ausgewählte Volumenelement angrenzenden Bereichen stammen, in denen das Magnetfeld stark inhomogen ist, was eine Kompensation der erhaltenen Meßwerte in bezug auf diese Inhomogenitäten erforderlich macht.

Es sind weitere Verfahren zum Messen der magnetischen Kernresonanz in ausgewählten Volumenelementen eines Körpers bekannt, die nicht den Zweck haben, ein hochaufgelöstes NMR-Spektrum der in dem Volumenelement enthaltenen Substanz zu erhalten, sondern durch Bestimmen der Dichteverteilung zu einer Bilddarstellung von Querschnittsebenenen des Körpers zu kommen. Solche Verfahren sind beispielsweise in DE-A2 716 492 und GB-A-2 026 172 beschrieben. Bei diesen Verfahren findet nicht nur unter einem Gradientenfeld eine selektive Anregung der in vorgegebenen Bereichen enthaltenen Kernspins statt, sondern es werden auch die Resonanzsignale unter herrschenden Gradientenfeldern beobachtet, um aus dem Frequenzspektrum der Resonanzsignale auf die Dichteverteilung der Kernspins in dem Bereich der darzustellenden Querschnittsfläche zu schließen.

Im Gegensatz dazu liegt der Erfindung die Aufgabe zugrunde, ein Verfahren für die räumlich lokalisierte KernresonanzSpektroskopie anzugeben, welches die Möglichkeit bietet, hochaufgelöste NMR-Spektren in Volumenelementen zu erhalten, deren Lage im Probenkörper in weiten Grenzen frei gewählt werden kann, ohne daß mechanische Änderungen an der Apparatur und/oder Verlagerungen des Probenkörpers erforderlich wären.

Diese Aufgabe wird nach der Erfindung dadurch gelöst, daß dem homogenen Magnetfeld ein erstes, gleichgerichtetes Gradientenfeld überlagert wird, dessen Stärke sich in einer ersten Richtung ändert, dann mittels erster HF-Signale geeigneter Trägerfrequenz, Amplitude und Phase einerseits die Gesamtheit der sich innerhalb des Körpers befindenden, ausgewählten Kernspins und andererseits selektiv nur die in einer das Volumenelement enthaltenden, zum Feldgradienten des ersten Gradientenfeldes senkrechten, ersten Körperschicht vorhandenen Kernspins derart angeregt werden, daß die in dieser Körperschicht enthaltenen, ausgewählten Kernspins zunächst aus der Richtung des homogenen Magnetfeldes heraus- und dann in diese Richtung zurückgedreht werden, während die außerhalb dieser Schicht liegenden Kernspins am Ende der Anregung eine von der Richtung des homogenen Magnetfeldes verschiedene Ausrichtung haben, daß danach das erste Gradientenfeld abgeschaltet und dem homogenen Magnetfeld ein zweites Gradientenfeld überlagert wird, das wiederum zum homogenen Magnetfeld gleichgerichtet ist und sich in einer zum ersten Feldgradienten senkrechten Richtung ändert, und dann mittels zweiter HF-Signale geeigneter Trägerfrequenz, Amplitude und Phase eine zweite Anregung der Gesamtheit der in dem Körper enthaltenen, ausgewählten Kernspins und selektiv der nur in einer das Volumenelement enthaltenden, zum Feldgradienten des zweiten Gradientenfeldes senkrechten zweiten Körperschicht stattfindet, wonach nur die Kernspins, die in einem durch das Schnittvolumen der ersten und der zweiten Körperschicht definierten Streifen enthalten sind, in die Richtung des homogenen Magnetfeldes zeigen, daß danach das zweite Gradientenfeld abgeschaltet und dem homogenen Magnetfeld ein drittes Gradientenfeld ürlagert wird, das zu dem homogenen Magnetfeld gleichgerichtet ist und sich in einer zu den Feldgradienten des ersten und des zweiten Gradientenfeldes senkrechten Richtung ändert, wonach mittels dritter HF-Sinale geeigneted -y- Trägerfrequenz, Amplitude und Phase eine dritte Anregung der Gesamtheit der ausgewählten Kernspins in dem Körper und selektiv nur der einer zu dem Streifen senkrechten, das Volumenelement enthaltenden dritten Körperschicht enthaltenen Kernspins vorgenommen wird, so daß jetzt nur noch die in dem ausgewählten Volumenelement enthaltenen Kernspins die gleiche Ausrichtung wie das homogene Magnetfeld aufweisen, daß danach auch das dritte Gradientenfeld abgschaltet wird und die in dem ausgewählten Volumenelement enthaltenen Kernspins mittels eines oder mehrerer HFImpulse zu einer ein Induktionssignal erzeugenden Schwingung angeregt werden.

Ebenso wie bei dem bekannten Verfahren wird auch bei dem erfindungsgemäßen Verfahren die Tatsache ausgenützt, Daß die Larmorfrequenz der Kernspins von der Stärke des Magnetfeldes abhängt, dem die Kernspins ausgesetzt sind, so daß bei Erzeugen eines Feldgradienten die Larmorfrequenz der Kernspins eine dem Verlauf des Feldgradienten folgende, räumliche Änderung erfährt und daher durch Auswahl der Anregungsfrequenz eine räumlich selektive Anregung der Kernspins erfolgen kann. Bei dem erfindungsgemäßen Verfahren werden jedoch keine komplizierten Gradientenfelder benötigt, sondern es können einfachelineare Gradientenfelder verwendet werden und es kann das ausgewählte Volumenelement durch Wahl der Frequenz des Anregungssignales beliebig längs des jeweiligen Feldgradienten verschoben werden. Durch die aufeinanderfolgende Anwendung von drei zueinander senkrechten Feldgradienten kann daher der Ort des ausgewählten Volumens in beliebiger Weise in dem durch die drei Feldgradienten definierten Koordinatensystem gewählt werden.

Ein besonderer Vorteil des erfindungsgemäßen Verfahrens besteht darin, daß die selektive Anregung immer in der Weise erfolgt daß sie dazu benutzt wird, eine Anregung der Gesamtheit der im Körper enthaltenen Kernspins rückgängig zu machen oder auf ganzzahlige Vielfache von 180° zu ergänzen, so daß die ausgewählten Kernspins nach jeder Anregung wieder die Richtung des homogenen Magnetfeldes einnehmen, während die anderen Kernspins damit einen Winkel bilden. Da die Anregungsvorgänge eine Zeit in Anspruch nehmen, die in der Regel größer ist als die Spin-Spin-Relaxationszeit $T_2$, findet eine Dispersion der übrigen Kernspins statt, die dazu führt, daß diese Kernspins schließlich keinen wesentlichen Signalbeitrag mehr liefern. Hierzu trägt auch bei, daß beim Umschalten der Gradientenfelder eine zusätzliche Dispersion der Kernspins stattfindet, deren Ausrichtung von der Richtung des homogenen Magnetfeldes verschieden ist. So wird auf sehr einfache Weise gewährleistet, daß nach der letzten Anregung nur noch die in dem ausgewählten Volumenelement enthaltenen Kernspins zur Richtung des homogenen Magnetfeldes parallel sind und daher nach Abschalten des letzten Gradientenfeldes für eine Messung zur Verfügung stehen. Sie können dann in üblicher Weise zur Durchführung jedes beliebigen KernresonanzExperimentes angeregt werden, beispielsweise durch einen 90°-Impuls oder euch durch eine Impulssequenz, wie sie zur Verbesserung des Signal/Rausch-Verhältnisses, zur Messung von von Relaxationszeiten und dgl. angewendet wird. Von besonderem Vorteil ist, daß bei der eigentlichen Messung ausschließlich das homogene Magnetfeld herrscht, das mit den aus der hochauflösenden NMR-Spektroskopie bekannten Methoden erzeugt werden kann, und daher eine völlig ungestörte Spektrenaufnahme möglich ist, ohne daß eine kompensation irgendwelcher Feldinhomogenitäten erforderlich wäre. Infolgedessen läßt sich nach dem erfindungsgemäßen Verfahren die hochauflösende NMB-Spektroskopie in einem ausgewählten Volumenelement eines großen Körpers mit der gleichen Präzision und Auflösung ausführen wie an kleinen, isolierten Proben. Zum Anregen der Kernspins bei eingeschalteten Gradientenfeldern können Signale verwendet werden, wie sie auch sonst in der NMR-Spektroskopie zur Anregung der Kernspins verwendet werden. So ist es insbesondere zweckmößig, jeweils zur Anregung der Gesamtheit der ausgewählten Kernspins einen 90°-Impuls zu verwenden. Insbesondere kann zur Anregung der Kernspins ein HF-Signal verwendet werden, das zunächst eine Drehung der in der jeweiligen Körperschicht angeordneten Kernspins um einen weniger als 90° betragenden Winkel α dann eine Drehung aller ausgewählten Kernspins um 90° undendlich wiederum eine Drehung der sich in der ausgewählten Ebene befindenden Kernspins um einen Winkel von (90° -α) bewirkt. Dabei können die Winkel α und (90° -α) zur 90°-Drehung, denen die Gesamtheit der Kernspins ausgesetzt ist, beide gleich oder entgegengesetzt gerichtet sein, wodurch entweder die ausgewählten Kernspins nach der Anregung wieder zum homogenen Magnetfeld gleich oder aber dazu entgegengesetzt gerichtet sind. Der Winkel α beträgt vorzugsweise 45°. Dabei ist es sowohl möglich, zur Anregung der Kernspins ein HF-Signal zu verwenden, das aus einer Folge voneinander getrennter Impulse mit verschiedenen Trägerfrequenzen und/ oder Amplituden und/oder Phasen besteht, oder aber ein HF-Signal, das von einem vorzugsweise symmetrischen Impuls mit wechselnder Trägerfrequenz und/oder Amplitude und/oder Phase gebildet wird.

Obwohl die oben behandelte Dispersion der nicht in der Richtung des homogenen Magnetfeldes zurückgedrehten, ausgewählten Kernspins zur Folge hat, daß sich die von diesen Kernspins gelieferten Induktionssignale gegenseitig aufheben, kann doch der Fall eintreten, daß auch diese Kernspins noch einen resultierenden Signalanteil liefern, der eine Störung für das aus dem ausgewählten Volumenelement stammende Signal darstellt. Das erfindungsgemäße Verfahren bietet die Möglichkeit, auch noch solche Störsignale zu eliminieren, indem in weiterer Ausgestaltung der Erfindung die Anregungen der Kernspins derart ausgeführt werden, daß die in dem ausgewählten Volumenelement enthaltenen Kernspins nach der letzten Anregung abwechselnd eine zur Richtung des homogenen Magnetfeldes gleiche und entgegengesetzte Ausrichtung haben und die bei solchen aufeinanderfolgenden Messungen erhaltenen Induktionssignale voneinander abgezogen werden. Bei dieser Ausgestaltung des erfindungsgemäßen Verfahrens sind die Induktionssignale, welche von den in dem ausgewählten Volumenelement enthaltenen Kernspins geliefert werden, jeweils gegenphasig, so daß sie sich bei der Subtraktion addieren, wogegen die von den übrigen Kernspins gelieferten Signalanteile gleichphasig sind und daher bei der Subtraktion verschwinden. Dieser Ausgestaltung des erfindungsgemäßen Verfahrens kann dann besondere Bedeutung zukommen, wenn Proben untersucht werden sollen, die eine relativ kleine Spin-Gitter-Relaxationszeit $T_1$ beeitzen, so daß die Anregungszeiten sehr kurz gehalten werden müssen, so daß eine nur ungenügende Dispersion der außerhalb des ausgewählten Volumenelementes liegenden Kernspins erreicht werden kann. In besonders kritischen Fällen kann es noch zweckmäßig sein, mindestens bei einem der eingeschalteten Gradientenfelder den Körper einem HF-Signal auszusetzen, das annähernd eine Sättigung der sich außerhalb der ausgewählten Körperschicht befindenden, ausgewählten Kernspins bewirkt, bevor die Kernspins den eigentlichen Anregungsfeldern ausgesetzt werden. Auf diese Weise können mögliche Störsignale noch weiter herabgedrückt werden.

Die Erfindung wird im folgenden anhand der in der Zeichnung dargestellten Diagramme näher beschrieben und erläutert. Es zeigen

Fig. 1 die schematische Darstellung eines Körpers mit einem ausgewählten Volumenelement und einem zugeordneten Koordinatensystem,

Fig. 2 ein Zeitdiagramm der bei der Durcführung des erfindungsgemäßen Verfahrens verwendeten Signale und

Fig. 3 und 4 Zeigerdiagramme zur Veranschaulichung der bei dem erfindungsgemäßen Verfahren auftretenden Anredungsvorgänge.

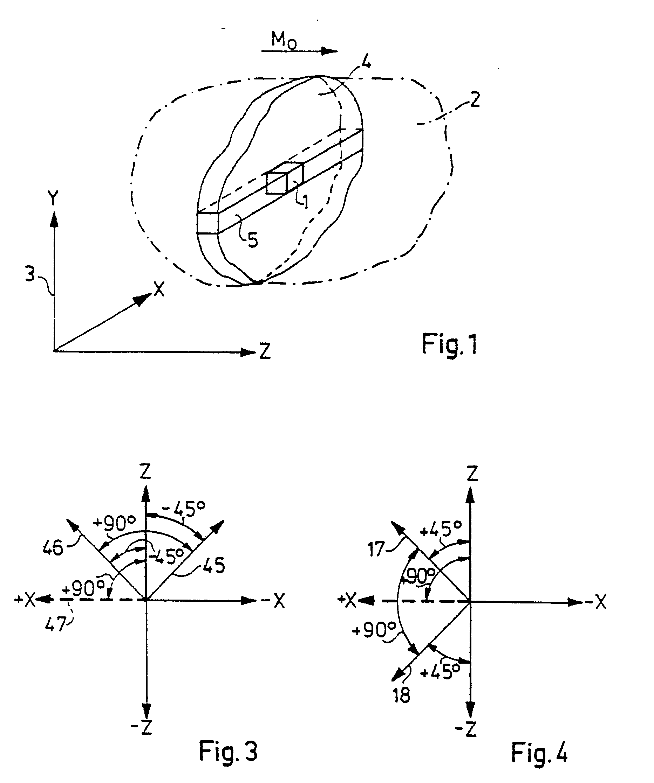

Fig. 1 veranschaulicht das Volumenelement 1 eines Körpers 2 beliebiger Gestalt, dessen Inhalt durch eine hochauflösende NMR-Spektroskopie untersucht werden soll. Zu diesem Zweck wird der Körper 2 einem homogenen Magnetfeld $M_0$ ausgesetzt, das sich in Richtung der Z-Achse eines zugeordneten Koordinatensystems 3 erstreckt. Die hochauflösende NMR-Spektroskopie erfordert eine Anregung ausgewälhter Kernspins, damit diese ein Induktionssignal liefern, das dann einer Fourier-Analyse unterworfen werden kann, um die Frequenzkomponenten des Induktionsignals zu ermitteln die Aufschluß,über die Art der untersuchten Substanz liefern. Um die Untersuchung auf das interessierende Volumenelement 1 zu beschränken, ist es erforderlich, daß nur die in diesem Volumenelement enthaltenen Kernspins selektiv angeregt werden.

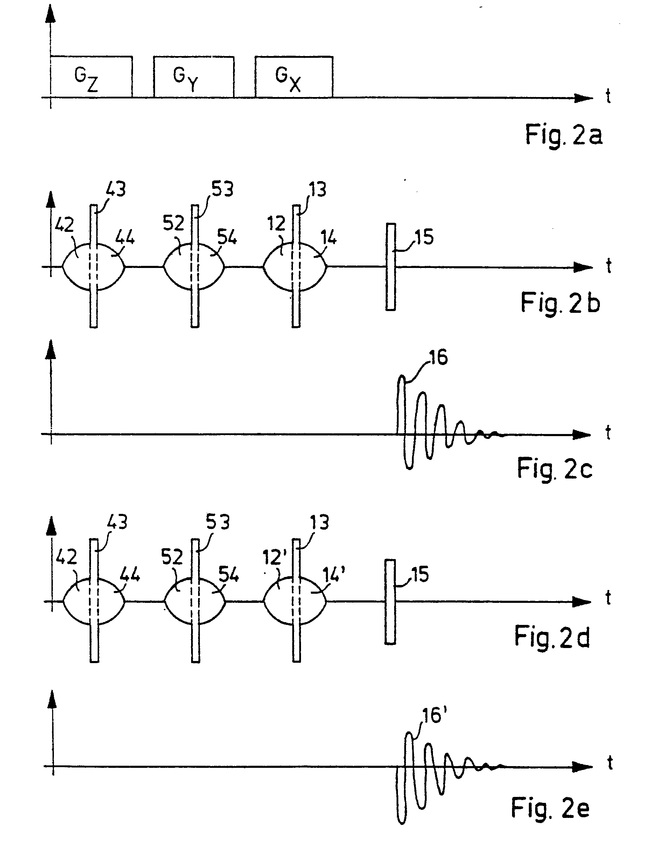

Um eine selektive Anregung der in dem Volumenelement 1 enthaltenen Kernspins zu ermöglichen, wird bei dem erfindungsgemäßen Verfahren zunächst dem homogenen Magnetfeld $M_0$ ein erstes Gradientenfeld $G_Z$ überlagert, das zum homogenen Magnetfeld $M_0$ gleicb gerichtet ist, dessen Stärke sich jedoch in Richtung der Z-Achse ändert, so daß ein Feldgradient in Z-Richtung entsteht. Demgemäß sind die Larmorfrequenzen einer im Körper 2 enthaltenen, ausgewählten Art-von Kernspins in Richtung der Z-Achse verschieden, so daß es möglich ist, durch Auswahl einer geeigneten Anregungsfrequenz alle diejenigen Kernspins selektiv enzuregen, die sich in einer zur Richtung des Feldgradienten, also in diesem Fall zur Richtung der ZAchse, senkrechten Ebene 4 befinden. Dementsprechend wird bei anliegendem Gradientenfeld $G_Z$ (Fig. 2a) der Körper 2 einem HF-Signal ausgesetzt, das aus drei Anteilen 42, 43,44 gleicher Trägerfrequenz, jedoch unterschiedlicher Amplitude und Phase besteht (Fig. 2b). Der Anteil 42 hat eine solche Einhüllende und Phase, daß die in der Ebene 4 enthelteten kernspins aus der Z-Richtung um -45° in der Z, x-Ebene verdreht werden, so daß sie die in Fig. 3 durch den Zeiger 45 dargestellte Lege einnehmen. Der Signalanteil 43 hat eine solche Phase und eine solche Einhüllende, daß die Gesamtbeit aller Kernspins im Körper 2 in der Z, X-Ebene um +90° verdreht werden, so daß die zuvor um -45° verdrehten kernspins der Ebene 4 nunmehr gegenüber der Z-Achse um +45° verdreht sind, wie es der Zeiger 46 in Fig. 3 angibt, während alle übrigen Kernspins bis in die X, Y-Ebene verdreht worden sind, wie es der gestrichelte Zeiger 47 in Fig. 3 veranschulicht. Der Signalanteil 44 bewirkt ebenso wie der erste Signalanteil 42 eine selektive Drehung der nur in der Ebene 4 entheltenen Kernspins um -45°, so daß die in dieser Ebene entheltenen Kernspins in die Z-Richtung zurückgedreht worden sind.

Danach wird das Gradientenfeld $G_Z$ ebgeschaltet und statt dessen das Gredientenfeld $G_Y$ engelegt, das wiederum die gleiche Richtung het wie das homogene Magnetfeld $M_0$, jedoch eine sich in Richtung der Y-Achse ändernde Feldstärke, so daß nunmehr ein Feldgradient in Y-Richtung vorliegt. Danach wird der Körper 2 wiederum einem HFSignal ausgesetzt, das drei Signalenteile 52, 53 und 54 umfaßt, von denen die Signalanteile 52 und 54 wiederum selektiv nur diejenigen kernspins um jeweils -45° verdrehen, die in einer zur Y-Achse senkrechten Ebene liegen, durch welche in der zuvor angeregten Scheibe 4 ein Streifen 5 angeregt wird, in dem eich das ausgewählte Volumenelement 1 befindet. Durch den Signalenteil 53 werden die außerhalb des Streifens 5 in der Ebene 4 gelegenen Kernspins wiederum um 90° in die X, Y-Ebene gedreht. Welche Drehungen dabei die eußerhalb der Ebene 4 im Körper 2 enthaltenen, bereits einmal angeregten Kernspins erfahren, ist unbestimmt, weil diese Kernspins sich inzwischen in der X, Y-Ebene weitgehend gleichmäßig verteilt haben, und zwar infolge der Spin-Spin-Relaxation sowie infolge der Änderungen der Magnetfeldstärke die beim Ein- und Ausschalten der Gradientenfelder entstehen.

Nach erfolgter Anregung zur Selektion des Streifens 5 wird das Gradientenfeld $G_Y$ abgeschaltet und statt dessen ein Gradientenfeld $G_X$ eingeschaltet, das wiederum zum homogenen Magnetfeld $M_O$ gleich gerichtet ist, dessen Feldstärke sich jedoch längs der X-Achse ändert. Demgemäß ist es möglich, durch Wahl der Larmorfrequenz einen Bereich selektiv anzuregen, der sich in einer bestimmten Stellung längs der X-Achse befindet, d.h. ein bestimmtes Volumenelement 1 im Streifen 5. Daher wird nunmehr bei anliegendem Gradientenfeld $G_X$ (Fig. 2a) der Körper 2 mit einem HF-Signal beaufschlagt, das drei Signalanteile 12, 13, 14 aufweist, von denen die Signalanteile 12 und 14 wieder in der beschriebenen Weise selektiv nur eine Drehung der im Volumenelement 1 enthaltenen Kernspins um jeweils -45° bewirkt, während durch den HF-Impuls 13 die Gesamtheit der im Körper 2 enthaltenen Kernspins und insbesondere die außerhalb des Volumenelementes 1 im Streifen 5 enthaltenen Kernspins um 90° gedreht werden. Nach dieser Anregung enthält nur noch das Volumenelement 1 Kernspins, die in ihrer Gesamtheit wieder in Richtung des homogenen Magnetfeldes $M_O$ zurückgedreht sind, also einen statischen Ruhezustand aufweisen, der weder durch Relaxationsvorgänge noch durch das Abschalten des Gradientenfeldes $G_X$ beeinflußt wird. Wird daher nach Abscbalten des Gradientenfeldes $G_X$ der körper 2 einem Anregungsimpuls 15 ausgesetzt, insbesondere einem 90°Impuls, so werden die im Volumenelement 1 enthaltenen Kernspins in ihrer Gesamtheit in die X, Y-Ebene gedreht und damit zur Erzeugung eines Induktionsignals 16 angeregt, das in üblicher Weise empfangen und weiter verarbeitet werden kann. Dagegen sind alle anderen Kernspins im Körper 2 weitgehend statistisch verteilt, so daß sie zwar auch nach der Anregung durch den Impuls 15 Induktionsignale liefern, diese Induktionsignale sich aber gegenseitig aufheben oder ausmitteln.

Für eine hohe Auflösung ist von besonderer Bedeutung daß während des eigentlichen Meßvorganges ausschließlich das homogene Magnetfeld $M_X$ vorliegt, so daß keine Störungen durch Magnetfeld-Gradienten auftreten können, und daß die Spins des ausgewählten Volumenelementes in dem homogenen Magnetfeld eine stationäre Ausrichtung haben, bevor sie beispielsweise mittels eines 90°-Impulses angeregt werden. Es ist daher auch möglich, anstelle eines einzigen 90°-Impulses solche Impulssequenzen zur Anregung der ausgewählten kernspins in dem ausgewählten Volumenelement zu verwenden, wie sie zur Verbesserung des Signal-Rausch-Verhältnisses sowie zur Ermittlung von Relaxationszeiten in der NMH-Spektroskopie allgemein Anwendung finden, wie beispielsweise eine Carr-Purcell-Folge.

Obwohl prinzipiell zu erwarten ist, daß sich die Induktionssignale, welche von den außerhalb des ausgewählten Volumenelementes 1 im Körper 2 vorhandenen, ausgewählten Kernspins geliefert werden, gegenseitig aufheben oder ausmitteln, kann es in der Praxis vorkommen, daß auch diese Kernspins einen resultierenden Signalanteil liefern, der sehr schnell in die Größenordnung des vom Volumenelement 1 gelieferten Signals kommen kann, weil das ausgewählte Volumenelement häufig nur einen sehr geringen Bruchteil des Gesamtkörpers bildet. Es ist ohne weiteres möglich, daß das Gesamtvolumen des Körpers das $10^4$-fache und mehr des Volumens des ausgewählten Volumenelementes 1 bildet. Daher liefern die im übrigen Körper 2 enthaltenen Kernspins schon dann ein resultierendes Signal, das in der Größenordnung des vom ausgewählten Volumenelement 1 gelieferten Signales liegt, wenn die oben erwähnte Selbstkompensation nur um das $10^{-3}$ bis $10^{-4}$-fache von der vollkommenen Auslöschung abweicht. Das erfindungsgemäße Verfahren ermöglicht es jedoch, auch solche, aus dem Volumen des Körpers 2 stammende Restsignale zu eliminieren.

Dazu wird das zuvor beschriebene Experiment zweifach durchgeführt, jedoch in der Weise, daß nach zwei aufeinanderfolgenden, selektiven Anregungsvorgänge die ausgewählten Kernspins im Volumenelement 1 abwechselnd die gleiche Ausrichtung haben wie das homogene Magnetfeld $M_O$ oder aber entgegengegetzt dazu gerichtet sind. Beispielsweise kann nach der in Fig. 2b dargestellten Anregung der Kernspins im Körper 2 bei einem darauffolgenden Meßvorgang eine Anregung stattfinden, wie sie durch Fig. 2d veranschaulicht wird. Hier erfolgt bei angelegten Gradientenfeldem $G_Z$ und $G_Y$ die gleiche Anregung durch die HF-Signale 42, 43, 44 bzw. 52, 53, 54, wie sie zuvor beschrieben worden ist. Nach Anlegen des Gradientenfeldes $G_X$ wird jedoch zum Anregen der Kernspins ein HF-Signal verwendet, dessen Signalanteile 12' und 14' jeweils eine selektive Drehung der nur im Volumenelement 1 enthaltenen Kernspins um +45° in der Z-X-Ebene bewirken.

Demgemäß werden die im Volumenelement 1 enthaltenen Kernspins, wie in Fig. 4 dargestellt, vom Signalanteil 12' aus der Z-Richtung um +45° in die Richtung gedreht, die in Fig. 4 durch den Zeiger 17 dargestellt ist. Bei der anschließenden Drehung aller Kernspins um 90° durch den Impuls 13 gelangen die Kernspins in dem Volumenelement 1 in die durch den Zeiger 18 veranschaulichte Steilung, in der sie gegenüber der Z-Richtung um 135° verdreht sind. Bei der letzten Drehung durch den Signalanteil 14' erreichen die Kernspins im Volumenelement 1 die -Z-Richtung. Werden nun diese Kernspins nach Abschalten des Gradientenfeldes $G_X$ durch einen 90°-Impuls 15 angeregt, so liefern sie ein Induktionssignal 16', das zu dem Induktionssignal 16 bei der vorhergehenden Messung um 180° phasenverschoben ist (Fig. 2e). Werden nun die bei aufeinanderfolgenden Messungen erhaltenen Induktionssignale 16 und 16' voneinander subtrahiert, so findet wegen der Gegenphasigkeit eine Addition der Absolutwerte statt. Dagegen habe die außerhalb des Volumenelementes 1 liegenden kernspins bei beiden Meßvorgängen genau gleichartige Anregungen erfahren, so daß insbesondere die in dem Streifen 5 enthaltenen, auß halb des Volumenelementes 1 gelegenen Kernspins beide Male in die X-Richtung gedreht worden sind und daher auch unter Berücksichtigung der Tatsache, daß sie nach der Anregung gleichartige Änderungen erfahren, gleiche resultierende Signale liefern, die sich bei der folgenden Subtraktion aufheben. Es versteht sich, daß genau das gleiche Ergebnis erzielt wird, wenn die Signalanteile abwechselnd so gewählt werden, daß die innerhalb des Volumenelementes 1 liegenden kernspins gleichphasige Signale und die außerhalb dieses Volumenelementes liegenden kernspins gegenphasige Signale liefern und sich diese Signale bei einer Addition der Signale aufheben.

In dem Fall, daß auch bei Anwendung dieser Subtraktionsbeziehungsweise Additionsmethode noch störende Signalreste übrig bleiben, besteht die Möglichkeit, bei anliegenden Gradientenfeldern selektive Sättigungssignale zu verwenden, um von vornherein die Anzahl der Kernspins, welche störende Signale liefern können, soweit wie nur möglich zu reduzieren. Da diese Sättigungssignale jedoch nicht zur selektion des ausgewählten Volumenelementes dienen, ist die Form dieser Sättigungssignale nicht sehr kritisch. Es genügt, wenn dadurch ein Großteil der im Körper 2 enthaltenen Kernspins durch die Sättigung daran gehindert wird, Signal, beiträge zu liefern, auch wenn die Grenzen des gesättigten Bereiches in der Umgebung des ausgewählten Volumenelementes nicht scharf definiert sind.

Das erfindungsgemäße Verfahren läßt sich ohne weiteres mit den Geräten durchführen, wie sie bisher in der hochauflösenden NMR-Spektrometrie und in der NMR-Tomographie verwendet werden und die beispielsweise Synthesizer und Impulsgeneratoren zur Erzeugung der notwendigen HF-Signale, die bekannten Einrichtungen zur Erzeugung eines starken, homogenen Magnetfeldes und der Gradientenfelder sowie die Einrichtungen zum Empfang und zur Analyse des Induktionssignales aufweisen.

## Patentansprüche

1. Verfahren zum Messen der magnetischen Kernresonanz in einem ausgewählten Volumenelement eines Körpers, bei dem die sich in dem ausgewählten Volumenelement (1) befindenden, interessierenden Kernspins mittels Hochfrequenzsignalen selektiv angeregt werden, während sie einem den gesamten Körper (2) durchsetzenden, hochgradig homogenen, stationären Magnetfeld ($M_O$) sowie stationären magnetischen Gradientenfeldern ($G_Z$, $G_Y$, $G_X$) ausgesetzt sind, und bei dem Induktionssignale (16, 16') erzeugt und detektiert werden, dadurch gekennzeichnet, daß dem homogenen Magnetfeld ($M_O$) ein erstes, gleichgerichtetes Gradientenfeld ($G_Z$) überlagert wird, dessen Stärke sich in einer ersten Richtung ändert, dann mittels erster HF-Signale geeigneter Trägerfrequenz, Amplitude und Phase einerseits die Gesamtheit der sich innerhalb des Körpers (2) befindenden, ausgewählten Kernspins und andererseits selektiv nur die in einer das Volumenelement (1) enthaltenden, zum Feldgradienten des ersten Gradientenfeldes senkrechten, ersten Körperschicht (4) vorhandenen Kernspins derart angeregt werden, daß die in dieser Körperschicht (4) enthaltenen, ausgewählten Kernspins zunächst aus der Richtung des homogenen Magnetfeldes ($M_O$) heraus und dann in diese Richtung zurückgedreht werden, während die außerhalb dieser Schicht liegenden Kernspins am Ende der Anregung eine von der Richtung des homogenen Magnetfeldes verschiedene Ausrichtung haben, daß danach das erste Gradientenfeld ($G_Z$) abgeschaltet und dem homogenen Magnetfeld ($M_O$) ein zweites Gradientenfeld ($G_Y$) überlagert wird, das wiederum zum homogenen Magnetfeld gleichgerichtet ist und sich in einer zum ersten Feldgradienten senkrechten Richtung ändert und dann mittels zweiter HF-Signale geeigneter Trägerfrequenz, Amplitude und Phase eine zweite Anregung der Gesamtheit der in dem Körper (2) enthaltenen, ausgewählten Kernspins und selektiv der nur in einer das Volumenelement (1) enthaltenden, zum Feldgradienten des zweiten Gradientenfeldes senkrechten zweiten Körperschicht stattfindet, wonach nur die Kernspins, die in einem durch das Schnittvolumen der ersten und zweiten Körperschicht definierten Streifen (5) enthalten sind, in die Richtung des homogenen Magnetfeldes ($M_O$) zeigen, daß danach das zweite Gradientenfeld ($G_X$) abgeschaltet und dem homogenen Magnetfeld ($M_O$) ein drittes Gradientenfeld ($G_X$) überlagert wird, das zu dem homogenen Magnetfeld gleichgerichtet ist und sich in einer zu den Feldgradienten des ersten und zweiten Gradientenfeldes senkrechten Richtung ändert, wonach mittels dritter HF-Signale geeigneter Trägerfrequenz, Amplitude und Phase eine dritte Anregung der Gesamtheit der ausgewählten Kernspins in dem Körper (2) und selektiv nur der in einer zu dem Streifen (5) senkrechten, das Volumenelement (1) enthaltenden dritten Körperschicht enthaltenen Kernspins vorgenommen wird, so daß jetzt nur noch die in dem ausgewählten Volumenelement (1) enthaltenen Kernspins die gleiche Ausrichtung wie das homogene Magnetfeld ($M_O$) aufweisen, daß danach auch das dritte Gradientenfeld ($G_X$) abgeschaltet wird und die in dem ausgewählten Volumenelement (1) enthaltenen, ausgewählten Kernspins mittels eines oder mehrerer HF-Impulse (15) zu einer ein Induktionssignal (16) erzeugenden Schwingung angeregt werden.

2. Verfahren nach Anspruch 1, dadurch gekennzeichnet, daß mindestens bei einem der eingeschalteten Gradientenfelder die Gesamtheit der ausgewählten Kernspins durch einen 90°-Impuls (43, 53, 13) angeregt wird.

3. Verfahren nach Anspruch 2, dadurch gekennzeichnet, daß mindestens bei einem der eingeschalteten Gradientenfelder zur Anregung der Kernspins ein HF-Signal (z.B. 42, 43, 44) verwendet wird, das zunächst eine Drehung der in der jeweiligen Körperschicht angeordneten Kernspins um einen weniger als 90° betragenden Winkel $\alpha$, dann eine Drehung aller ausgewählten Kernspins um 90- und endlich wiederum eine Drehung der sich in der ausgewählten Ebene (4) befindenden Kernspins um einen Winkel von (90° - $\alpha$) bewirkt.

4. Verfahren nach Anspruch 3, dadurch gekennzeichnet, daß der Winkel $\alpha$ 45° beträgt.

5. Verfahren nach einem der vorhergehenden Ansprüche, dadurch gekennzeichnet, daß mindestens bei einem der eingeschalteten Gradientenfelder das zur Anregung der Kernspins verwendete HF-Signal aus einer Folge voneinander getrennter Impulse mit verschiedenen Trägerfrequenzen und/oder Amplituden und/oder Phasen besteht.

6. Verfahren nach einem der vorhergehenden Ansprüche, dadurch gekennzeichnet, daß mindestens bei einem der eingeschalteten Gradientenfelder das zur Anregung der Kernspins verwendete HF-Signal von einem vorzugsweise symmetrischen Impuls (42, 43, 44) mit Anteilen unterschiedlicher Trägerfrequenz und/oder Amplitude und/oder Phase gebildet wird.

7. Verfahren nach einem der vorhergehenden Ansprüche, dadurch gekennzeichnet, daß die Anregungen der Kernspins derart ausgeführt werden, daß die in dem ausgewählten Volumenelement (1) enthaltenen Kernspins nach der letzten Anregung abwechselnd eine zur Richtung des homogenen Magnetfeldes ($M_O$) gleiche und entgegengesetzte Ausrichtung haben und die erhaltenen Induktionssignale (16, 16') voneinander abgezogen werden.

8. Verfahren nach einem der vorhergehenden Ansprüche, dadurch gekennzeichnet, daß mindestens bei einem der eingeschalteten Gradientenfelder der Körper einem HF-Signal ausgesetzt wird, das annähernd eine Sättigung der sich außerhalb der ausgewählten Körperschicht befindenden, ausgewählten Kernspins bewirkt, bevor die Kernspins den Anregungsfeldern ausgesetzt werden.

1. Method for measuring the nuclear magnetic resonance in a selected volume element of a body, in which the nuclear spins of interest located in the selected volume element (1) are excited selectively by means of high frequency signals, whilst they are exposed to a highly homogeneous, stationary magnetic field ($M_O$ passing through the entire body (2) and to stationary magnetic gradient fields ($G_Z$, $G_Y$, $G_X$ and in which induction signals ( 16, 16') are produced and detected, characterised in that a first unidirectional gradient field ($G_Z$ is superimposed on the homogeneous magnetic field ($M_O$, the intensity of which gradient field varies in a first direction, then by means of first HF-signals of suitable carrier frequency, amplitude and phase, on the one hand all the selected nuclear spins located within the body (2) and on the other hand selectively only the nuclear spins present in a first layer (4) of the body, containing the volume element (I) and at right angles to the field gradient of the first gradient field are excited so that the selected nuclear spins contained in this layer (4) of the body are first of all rotated out of the direction of the homogeneous magnetic field ($M_O$ and then rotated back in this direction, whereas at the end of the excitation, the nuclear spins located outside this layer have an alignment differing from the direction of the homogeneous magnetic field, that then the first gradient field ($G_Z$ is de-energised and a second gradient field ($G_Y$) is superimposed on the homogeneous magnetic field ($M_O$, which second gradient field is again unidirectional with respect to the homogeneous magnetic field and changes in a direction at right angles to the first field gradient and then by means of second HF-signals of suitable carrier frequency, amplitude and phase, a second excitation of all the selected nuclear spins contained in the body (2) and selectively of the nuclear spins present in a second layer of the body containing the volume element (1) and at right angles to the field gradient, of the second gradient field takes place, whereafter solely the nuclear spins, which are contained in a strip (5) defined by the common volume of the first and second layers of the body, point in the direction of the homogeneous magnetic field ($M_O$), that then the second gradient field ($G_Y$ is de-energised and a third gradient field ($G_X$) is superimposed on the homogeneous magnetic field ($M_O$), which is unidirectional with respect to the homogeneous magnetic field and changes in a direction at right angles to the field gradient of the first and second gradient field, whereupon by means of third HF-signals of suitable carrier frequency, amplitude and phase, a third excitation of all of the selected nuclear spins in the body (2) and selectively only the nuclear spins contained in a third layer of the body at right angles to the strip (5) and containing the volume element ( I) is carried out, so that now only the nuclear spins contained in the selected volume element (1) have the same alignment as the homogeneous magnetic field ($M_O$), that then also the third gradient field ($G_X$) is de-energised and the selected nuclear spins contained in the selected volume element (I) are excited by means of one or more HF-pulses (I5) resulting in an oscillation producing an induction signal (I6).

2. Method according to Claim I, characterised in that at least in one of the gradient fields in operation, all the selected nuclear spins are excited by a 90°-pulse (43, 53,I3).

3. Method according to Claim 2, characterised in that at least in one of the gradient fields in operation for exciting the nuclear spin, an HF-signal (for example 42, 43, 44) is used, which first of all brings about a rotation of the nuclear spin located in the respective layer of the body by an angle $\alpha$ amounting to less than 90°, then a rotation of all the selected nuclear spins by 90° and finally once more a rotation of the nuclear spins located in the selected plane (4) by an angle of ( 90° - $\alpha$)

4. Method according to Claim 3, characterised in that the angle $\alpha$ amounts to 45°.

5. Method according to one of the preceding Claims, characterised in that at least in one of the gradient fields in operation, the HF-signal used for the excitation of the nuclear spins consists of a sequence of pulses separated from each other with different carrier frequencies and/or amplitudes and/or phases.

6. Method according to one of the preceding Claims, characterised in that at least with one of the gradient fields in operation, the HF-signal used for exciting the nuclear spin is formed by a preferably symmetrical pulse (42, 43, 44) with portions of different carrier frequency and/or amplitude and/or phase.

7. Method according to one of the preceding Claims, characterised in that the excitations of the nuclear spins are carried out so that after the last excitation, the nuclear spins contained in the selected volume element (I) alternately have an alignment identical to the direction of the homogeneous magnetic field ($M_O$) and an opposite alignment and the induction signals (I6, I6') produced are substracted from each other.

8. Method according to one of the preceding Claims, characterised in that at least with one gradient field in operation, the body is subjected to an HF-signal, which nearly brings about a saturation of the selected nuclear spins located outside the selected layer of the body, before the nuclear spins are subjected to the excitation fields.

## Revendications

1/ procédé pour mesurer la résonnance magnéque nucléaire dans un élément de volume déterminé d'un corps, dans leguel les spins intéressants se trouvant dans l'élément de volume déterminé (1) sont excités de manière sélective au moyen de signaux haute fréquence, tandis gu'ils sont exposés à un champ magnétique stationnaire ($M_O$) fortement homogène, traversant la totalité du corps (2) ainsi gu'à des champs de gradient magnétique stationnaires ($G_Z$, $G_X$, $G_Y$ ) et dans leguel des signaux d'induction (16,16') sont produits et détectés, caractérisé en ce que:

- on superpose au champ magnétique homogène ($M_O$) un premier champ de gradient ($G_Z$) qui lui est parallèle et dont l'intensité varie dans une première direction, puis au moyen de premiers signaux (HF) de fréquence , amplitude et phase porteuses appropriées d'une part la totalité des spins déterminés se trouvant à l'extérieur du corps et d'autre part de manière sélective seulement les spins présents dans une première couche (4) du corps contenant l'élément du volume (1) et perpendiculaire au gradient du premier champ de gradient, sont excités de telle sorte que les spins déterminés contenus dans cette couche (4) du corps sont d'abord détournés de la direction du champ magnétique homogène $M_O$ puis ramenés dans cette direction, tandis que les spins situés hors de cette couche ont, à la fin de l'excitation, une orientation différente de celle du champ magnétique homogène ;

- ensuite, le premier champ de gradient ($G_Z$) est coupé et, au champ magnétique homogène ($M_O$) est superposé un second champ de gradient ($G_Y$), qui de nouveau est oriente comme le champ magnétique homogène et varie dans une direction perpendiculaire au gradient du premier champ ;

- et ensuite, au moyen de seconds signaux HF de fréquence, amplitude et phase porteuses appropriées, se produit une seconde excitation de la totalité des spins déterminés contenus dans le corps (2), et de manièresélective des spins seulement dans une seconde couche du corps contenant l'élément de volume (1) et perpendiculaire au gradient du second champ de gradient, après guoi seuls les spins, qui sont contenus dans une bande (5) définie par le volume de section de la première et de la seconde couches du corps, présentent l'orientation du champ magnétique homogène $M_O$

- après cela, le second champ de gradient ($G_Y$) est coupé et au champ magnétique homogène ($M_O$) est superpose un troisième champ de gradient ($G_X$), qui est parallè1e au champ magnétique homogène et varie dans une direction perpendiculaire au gradient des premier et second champs de gradient, après quoi, au moyen de troisièmes signaux HF de fréguence, amplitude et phase porteusesappropriées, on procède à une troisième excitation de la tota1ité des spins déterminés du corps (2) et de manière sélective, des seuls spins contenus dans une troisième couche de corps perpendiculaire à la bande (5) et contenant l'élement de volume (1), de sorte que maintenant seuls les spins contenus dans 1'élément de volume (1) déterminé sont parallèles au champ magnétique homogène ($M_O$) ;

- après cela, le troisième champ de gradient ($G_X$) est éga1ement coupé et les spins déterminés contenus dans 1'élément de volume (1) determiné sont, au moyen d'une ou plusieurs impulsions HF (15),excités jusqu,à une vibration produisant un signal d'induction (16).

2/ Procédé selon la revendication 1, caractérisé en ce que au moins pour un des champs de gradient branchés, on excite la totalité des spins déterminés, par une impulsion à 90° (43,53,13).

3/ Procédé selon la revendication 2, caractérisé en ce gue, au moins pour un des champs de gradient branchés, on utilise, pour exciter les spins, un signal HF (par exemple 42,43,44), qui exerce une rotation d'abord des spins disposés dans la couche du corps correspondant d'un angle $\alpha$ inférieur à 90°, puis de tous les spins déterminés de 90° et enfin à nouveau des spins se trouvant dans le plan déterminé (4) d'un angle de (90° -$\alpha$).

4/ procédé selon la revendication 3, caractérisé en ce que l'angle $\alpha$ est de 45°.

5/ Procédé selon l'une des revendications précédentes, caractérisé en ce que, au moins pour l'un des champs de gradient branchés, le signal HF utilisé pour exciter les spins se compose d'une suite d'impulsions distinctes les unes des autres par différentes fréquence et/ou amplitude et/ou phase porteuses.

6/ Procédé selon l'une des revendications précédentes, caractérisé en ce que, pour au moins l'un des champsde gradients branchés, le signal HF uti1isé pour l'excitation des spins est forme d'une impulsion (42,43,44) de préférence symétrique avec des proportions de fréquence et/ou amplitude et/ou phase porteuses différentes.

7/ Procédé selon l'une des revendications précédentes, caractérisé en ce que les excitations des spins sont effectuées de telle sorte que les spins contenus dans l'élément de volume determiné sont alternativement parallèles et antiparallèles au champ magnétique homogène ($M_O$) et que les signaux d'induction (16,18') obtenus sont séparés les uns des autres.

8/ Procédé selon l'une des revendications précédentes, caractérisé en ce que, au moins pour l'un des champs de gradients branchés, le corps est exposé à un signal HF gui effectue approximativement une saturation des spins déterminés se trouvant à l'extérieur de la couche du corps choisie, avant que les spins soient exposés au champ d'excitation.

½

Fig. 1

Fig. 3

Fig. 4

2/2

Fig. 2a

Fig. 2 b

Fig. 2c

Fig. 2 d

Fig. 2 e